# EUROPEAN PATENT SPECIFICATION

(11) **EP 4 710 330 B1**
(45) Date of publication and mention of the grant of the patent: **11.11.2026**
(21) Application number: 24738181.7
(22) Date of filing: 13.06.2024
(51) Int. Cl.: G11C 29/14, G11C 29/26, G11C 7/10, G11C 8/16

(54) **MULTI-PORT MEMORY TESTING**
MULTIPORT-SPEICHERPRÜFUNG
TEST DE MÉMOIRE MULTIPORT

(30) Priority: 16.02.2024 US 202463554785 P
(43) Date of publication of application: 18.03.2026
(73) Proprietor: Google LLC, Mountain View, CA 94043 (US)
(72) Inventor: ALI, Naushad, Mountain View, California 94043 (US); PARASRAMPURIA, Mayank, MOUNTAIN VIEW, California 94043 (US); TULSYAN, Shivam, MOUNTAIN VIEW, California 94043 (US); KULSHRESTHA, Ayush, Mountain View, California 94043 (US); SHAMANNA, Gururaj K, Mountain View, California 94043 (US); M, Naveen Kumar, Mountain View, California 94043 (US)
(74) Representative: Marks & Clerk GST
(86) International application number: PCT/US2024/033855
(87) International publication number: WO 2025/174400

(56) References cited:
- US-A1- 2007 070 743
- US-A1- 2007 242 553
- US-A1- 2009 150 621
- US-A1- 2022 101 896

## Description

### BACKGROUND

As a result of the ever-increasing complexity of computing systems, many systems implement memories that enable concurrent access by multiple system components. These memories typically include multiple read ports and multiple write ports such that several memory clients can access the memory during a same clock cycle. With several clients accessing the memory during the same clock cycle, however, constraints are placed on memory access to prevent two clients from attempting to write to or read from the same memory location to prevent data corruption. The access constraints also apply when testing the memory, such as during post manufacturing test for logic and memory cell testing. Because testing processes are often restricted to one pair of read and write ports, each testing process is repeated several times, which in turn increases memory test time and associated costs, particularly when a system includes multiple memories. US 2007/242553 A1 describes a semiconductor memory device including plural ports for transmitting an input data serial-interfaced with an external device into a global data bus, plural banks for parallel-interfacing with the plural ports through the global data bus, plural input signal transmission blocks, responsive to a mode register enable signal, for transmitting an input signal parallelinterfaced with the external device into the global data bus, and a mode register set for determining one of a data access mode and a test mode based on the input signal input through the global data bus. US 2022/101896 A1 describes a memory structure having 2m read ports allowing for concurrent access to n data entries can be constructed using three memory structures each having 2' read ports. The three memory structures include two structures providing access to half of the n data entries, and a difference structure providing access to difference data between the halves of the n data entries. Each pair of the 2m ports is connected to a respective port of each of the 2m-1-port data structures, such that each port of the part can access data entries of a first half of the n data entries either by accessing the structure storing that half directly, or by accessing both the difference structure and the structure containing the second half to reconstruct the data entries of the first half, thus allowing for a pair of ports to concurrently access any of the stored data entries in parallel.

### SUMMARY

This document describes apparatuses and techniques for improved testability for multi-port memory. A multi-port memory includes an array of memory cells organized into multiple banks of memory cells and interface logic with multiple read interfaces, the multiple read interfaces including a first read interface and a second read interface for the multiple banks of memory cells. The multi-port memory also includes test circuitry configured to receive, for the first read interface, a first address to read data from one bank of memory cells and receive, for the second read interface, a second address to read data from the same bank of memory cells, the first address being different from the second address. The test circuitry causes the interface logic to read the data from the bank of memory cells based on the address received for the read interface that is designated as a primary read interface for testing the multi-port memory and provides the data read from the bank of memory cells to both of the first read interface and the second read interface of the multi-port memory. By so doing, the test circuitry can control a response of the multi-port memory to enable concurrent same bank array testing, which can reduce test constraints and time consumed during testing.

In other aspects, a multi-port memory includes an array of memory cells organized into multiple banks of memory cells and interface logic comprising multiple read interfaces, the multiple read interfaces including a first read interface and a second read interface for the multiple banks of memory cells. A memory select circuit of the multi-port memory is configured to selectively provide a memory address to respective address logic of the first read interface and the second read interface. The multi-port memory includes a comparison circuit coupled to respective output ports of the first read interface and the second read interface, the comparison circuit includes exclusive OR (XOR) gates configured to implement a bit-wise comparison between respective data read results provided at the output ports of the first read interface and the second read interface. A logic circuit of the multi-port memory is configured to receive, from the comparison circuit, an indication of a mismatch between the respective data read results of the first read interface and the second read interface. The logic circuit may provide the indication of the mismatch to a test data register to flag a data error in the output of the output ports of the read interfaces.

This Summary is provided to introduce simplified concepts for multi-port memory testing, which are further described below in the Detailed Description and are illustrated in the Drawings. This Summary is not intended to identify essential features of the claimed subject matter, nor is it intended for use in determining the scope of the claimed subject matter.

### BRIEF DESCRIPTION OF THE DRAWINGS

The details of one or more aspects of multi-port memory testing are described throughout the disclosure with reference to the Drawings. The use of the same reference numbers in different instances in the description and the figures indicates same or similar elements:
Fig. 1 illustrates an example operating environment in which aspects of multi-port memory testing can be implemented;
Fig. 2 illustrates example testing environment in which a multi-port memory can implement aspects of testing in accordance with one or more aspects;
Fig. 3 illustrates an example of test circuitry implemented in a multi-port memory in accordance with one or more aspects;
Fig. 4 illustrates an example test wrapper of a multi-port memory implemented in accordance with one or more aspects;
Fig. 5 illustrates an example one hot controller that can implement aspects of multi-port memory testing;
Fig. 6 illustrates an example comparison circuit that can implement aspects of multi-port memory testing;
Fig. 7 illustrates an example method for testing a multi-port memory in accordance with one or more aspects;
Fig. 8 illustrates an example method for testing multiple read interfaces of a multi-port memory;
Fig. 9 illustrates an example method for detecting a mismatch between respective outputs of multiple read interfaces; and
FIG. 10 illustrates an example System-on-Chip in which aspects of multi-port memory testing may be implemented.

### DETAILED DESCRIPTION

With increasing power, performance, and area optimization demands for memory circuits, many system architects are designing complex custom memories, which are often referred to a multi-read/multi-write (mRmW) memories. These mRmW may be referred to as multi-port memories with multiple read interfaces (e.g., n - read ports) and/or multiple write interfaces (e.g., m - write ports) that enable concurrent access or operations by entities of a computing or processing system. While multi-port memories generally improve performance over single-port memories, preceding memory testing methodologies based on single-port memories are unable to account for the increased complexity of multi-port memories, resulting in slow and inefficient testing.

For example, bit-cell testing or memory built-in self test (MBIST) tools typically test a multi-port memory by treating the memory as multiple single port or 1R1W memories and iterate a test algorithm over each pair of read/write interface pair of the multi-port memory. In some cases, preceding techniques may run iterative testing over interfaces read_1+write_1 (R1+W1), R2+W2, R3+W3, and so forth with limited shadow testing between non-correlated ports to test for inter-port coupling. Thus, testing a 2R1W memory will consume twice as much test time compared to a single-port memory with a same number of bit-cells and testing a 10R8W memory will consume ten times more test time. In other words, all the extra test time is associated with testing all the combinations of interface logic of the multiple read and multiple write ports of the memory and not the bit-cells. Although bit-cell testing often requires more complex MARCH algorithms, testing the interface logic of the multiple interfaces can be accomplished through simpler and less time intensive algorithms.

Additionally, multi-port memories may have access restrictions on various combinations of read and/or write operations to maintain data integrity between memory operations. For logic testing, such as automatic test pattern generation (ATPG) testing, these access restrictions often force test engineers to build restrictions into the memory test tools during development that result in higher pattern counts to work around the access restrictions. Some of the access restrictions include preventing a read from a same bank array or bank of memory cells through multiple read interfaces. Programmatically, this can be expressed as "((RE1 ==1 and RE2==1) && (AR1[MSB] XOR AR2[MSB])) == FALSE", where RE is Read_Enable for the respective interfaces and AR is the read address to be accessed with a most significant bit (MSB) acting as bank selection. In the context of a 2R1W memory, the probability of this being true is 12.5%, which translates into the test tools rejecting 12.5% patterns it generates. Further, the access restrictions include preventing a write operation and a read operation into a same memory address during a single clock cycle. Programmatically, this can be expressed as "((RE1 ==1 and WE==1) && (AW == AR1)) OR ((RE2 ==1 and WE==1) && (AW = AR2)) == FALSE", where WE is Write_Enable for the interface and AW is the write address to be accessed. This same address restriction has a 1.18% probability of being true and thus the test tools will reject 1.18% of patterns due to this restriction.

In contrast with preceding test techniques, this disclosure describes aspects of multi-port memory testing that include memory test circuitry and/or a memory test wrapper can enable memory testing in ways that are not restricted by the aforementioned constraints. In some aspects of multi-port memory testing, a multi-port memory may include memory test circuitry (test circuitry) that can provides or controls a defined response to same bank access made through multiple interfaces. Alternatively or additionally, a multi-port memory may include a memory test wrapper (test wrapper) that implements a fault monitor circuit to flag a mismatch between respective data outputs of multiple read interfaces. Thus, the aspects of multi-port memory testing described herein may address previous constraints on memory testing to reduce test pattern rejections by approximately 13% while achieving complete test coverage (e.g., for MBIST). By so doing, the aspects described herein can reduce test time, increase test coverage, with minimal costs in design area (e.g., low complexity logic).

In various aspects, a multi-port memory with multiple read interfaces is implemented with test circuitry for the multiple read interfaces and a test wrapper with fault monitoring on outputs of the read interfaces. The test circuitry may enable same bank access during testing by controlling a response provided at the outputs of the multiple read interfaces. The test wrapper can selectively broadcast address information to multiple read interfaces or a single read interface during testing. The test wrapper may also implement fault detection across the outputs of the multiple read interfaces to flag a data mismatch between the read interfaces. As such, the test circuitry and test wrapper can reduce testing constraints and reduce test time for multi-port memories.

This document describes apparatuses and techniques for multi-port memory testing, which may reduce constraints associated with testing multi-port memories to enable quicker or more efficient memory testing. The following discussion describes an operating environment, example implementations of various test circuitry and wrappers, and example methods that may be implemented for testing multi-port memories. In the context of the present disclosure, reference is made to the operating environment by way of example only.

### Example Environment

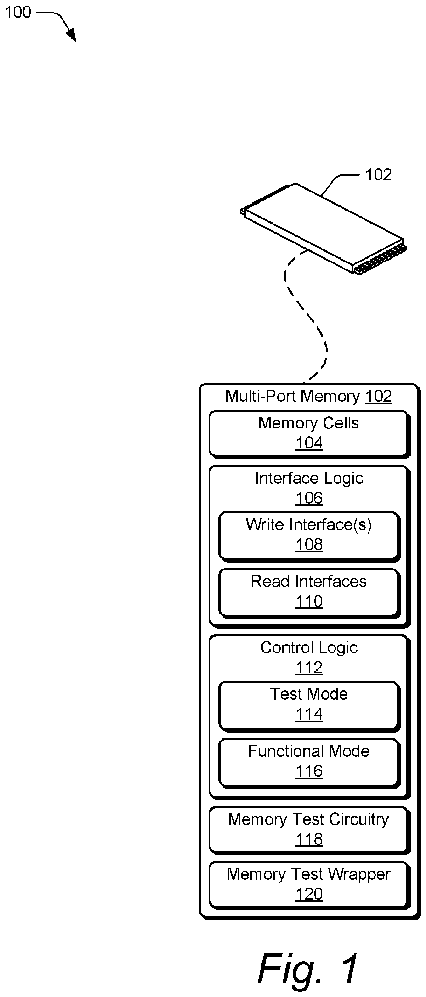

Fig. 1 illustrates an example environment 100 in which a multi-port memory 102 may implement aspects of multi-port memory testing as described herein. In some implementations, the multi-port memory 102 can be configured to store various data, code, instructions, or other information of an electronic device. For example, one or more instances of a multi-port memory may be implemented in any suitable electronic device, which may include a smart-phone, a tablet computer, a laptop computer, a gaming console, a desktop computer, a server computer, a wearable computing device (e.g., smart-watch), a broadband router (e.g., mobile hotspot), a mobile station (e.g., fixed- or mobile-STA), a mobile communication device, a user equipment, an entertainment device, a personal media device, a media playback device, a health monitoring device, a drone, a camera, an Internet home appliance capable of wireless Internet access and browsing, an IoT device, and/or other types of electronic devices.

The multi-port memory 102 includes memory cells 104, which may include arrays of memory cells organized into banks or bank arrays. The multi-port memory 102 also includes interface logic 106 that includes at least one write interface 108 configured to write data to banks of the memory cells 104 and multiple read interfaces 110 configured to read data from the banks of memory cells 104. In some aspects, the banks of memory cells are configured as rows that may be accessed for read operations or write operations through addresses provided to respective address logic of a write interface 108 or a read interface 110.

In some aspects, the multi-port memory 102 also includes control logic 112, such as a configuration register or test data register, that enables or selectively operates the multi-port memory 102 in a test mode 114 or a functional mode 116 (e.g., mission mode). For example, the control logic 112 may be accessed using a test interface, such as internal joint test action group (iJTAG), to set the multi-port memory 102 to the test mode 114 as described herein. The multiport memory 102 also includes memory test circuitry 118 (test circuitry 118) and a memory test wrapper 120 (test wrapper 120).

Generally, the test circuitry 118 may enable same bank access by controlling a response provided at the outputs of the multiple read interfaces 110. The test circuitry 118 is configured such that the multiple read interfaces 110 are assigned respective precedence levels or priority levels to determine a response of the memory when same bank access occurs during testing. Thus, when same bank access is attempted by the test algorithm, the data read provided at the output logic of the bank array follows the read interface 110 with the highest precedence or priority level (and disregard other interfaces with lower precedence). This may enable the test algorithm to implement test patterns or test configurations that were previously constrained with preceding testing techniques.

In aspects, the test wrapper 120 can selectively broadcast address information to all or a subset of the multiple read interfaces 110 or a single read interface 110 during testing. The test wrapper 120 may also implement fault detection across the outputs of the multiple read interfaces 110 to flag a data mismatch between the read interfaces 110. For example, when implementing an MBIST test, the test wrapper 120 can broadcast address information to the multiple read interfaces 110 to read from a same memory location with a bit-cell array or bank array. The test wrapper 120 can then implement a bit-wise comparison across the respective outputs of the read interfaces 110 and detect any bit mismatches between the respective outputs that should have a same bit pattern due to the broadcasting of the address information across the read interfaces 110. By so doing, the test circuitry 118 and/or the test wrapper 120 as described herein can reduce testing constraints and reduce test time for multi-port memories.

Generally, the multi-port memory 102 may be configured as any suitable type of memory media or storage media for an electronic device, such as read-only memory (ROM), programmable ROM (PROM), random access memory (RAM), dynamic RAM (DRAM), static RAM (SRAM), or Flash memory. In the context of this discussion, memory cells 104, which may also be referred to as computer-readable media (CRM), are implemented as hardware-based or physical memory circuitry (e.g., cell-bit arrays and associated access logic), which does not include transitory signals or carrier waves. When implemented in an electronic device, various applications, firmware, data, and/or an operating system of the electronic device can be stored by the memory cells 104 of the multi-port memory 102 and access by a processor of the device to implement various device functionalities.

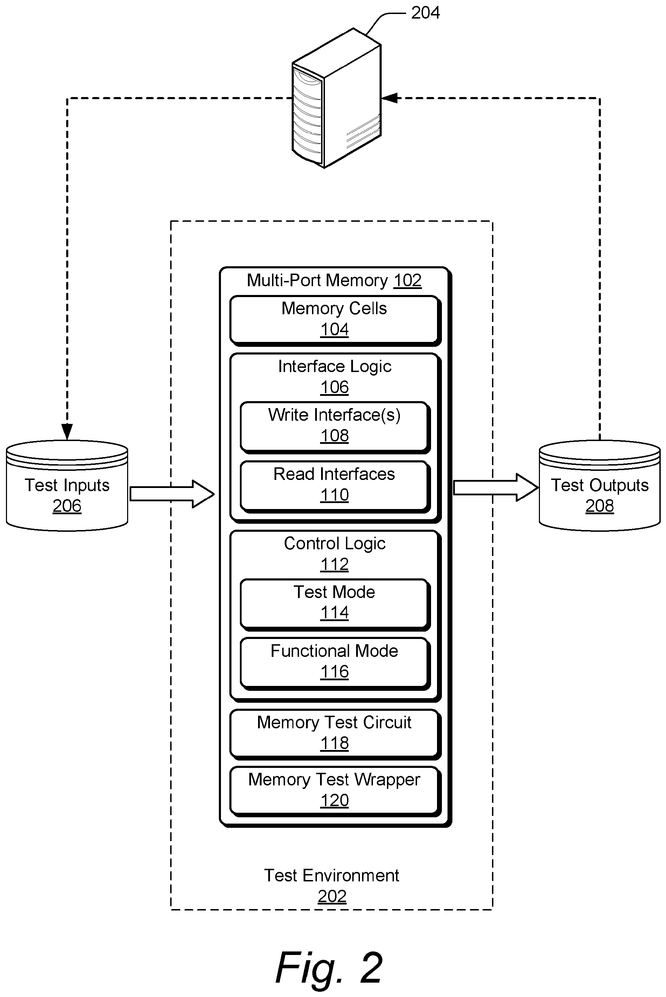

Fig. 2 illustrates at 200 an example testing environment in which a multi-port memory can implement aspects of testing in accordance with one or more aspects. The test environment 202 may include any suitable environment or memory device mode in which a test host 204 applies test inputs 206 to the multi-port memory 102 to obtain test outputs 208, which can be compared to expected responses to evaluate operation or performance of the multi-port memory 102. In aspects, the test host 204 applies various test tools, such as MBIST or ATPG, to generate the test inputs 206 applied to the multi-port memory 102. Generally, the test inputs 206 may any suitable type of data, address information, controls signals, settings, or the like. Based on the test inputs 206, the test host 204 can obtain or capture the test outputs 208 at respective outputs of the read interfaces 110 and/or from other status or output indicators (e.g., test wrapper 120 indicators or flags) of the multi-port memory 102 as described herein.

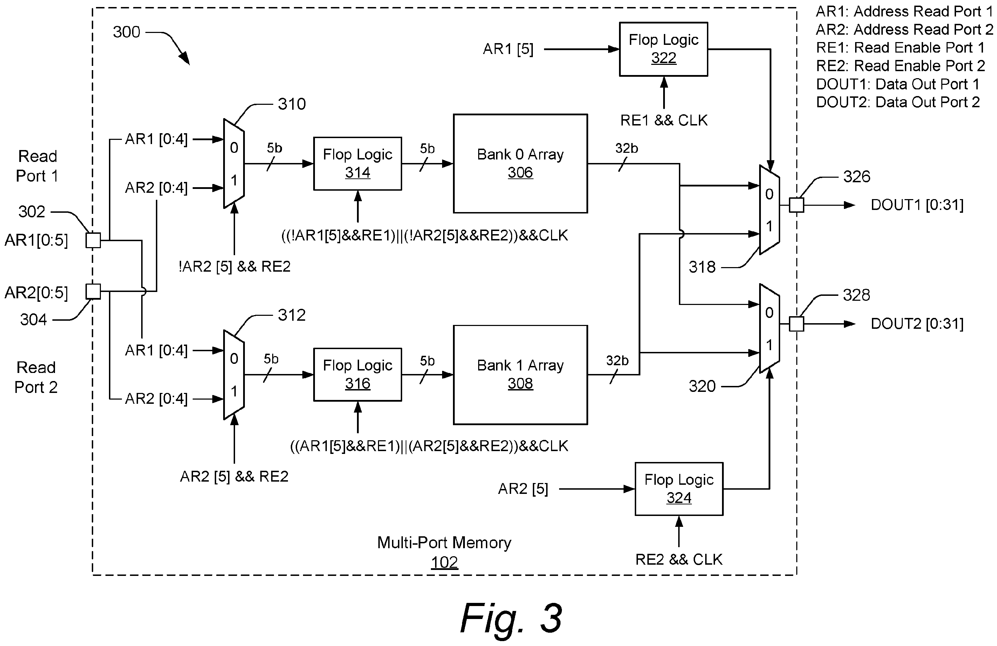

Fig. 3 illustrates at 300 an example of test circuitry implemented in a multi-port memory in accordance with one or more aspects. Although shown in the context of a multi-port memory 102 with two read interfaces, the test circuitry 118 may be applicable to or expanded across any suitable number of multiple read interfaces of a multi-port memory. As shown in Fig. 3, the multi-port memory 102 includes two read interfaces 110 (Read Port 1 and Read Port 2) with respective address logic ports 302 and 304 at which address information can be received. In this example, the read interfaces 110 may be configured with address logic or an address bus of "n" bits such that each port may receive a read address of n bits (AR1 [0:n-1] and AR2 [0:n-1]) where the most significant bit (MSB) of each read address ( $AR 1 \left⌈n-1\right⌉$ and $AR 2 \left⌈n-1\right⌉$) determines which of bank 0 array 306 or bank array 308 that read logic of the multi-port memory accesses for a read operation. Generally, other bits on the address logic or address bus [0:(n-2)] determine which row or memory location the read logic accesses within the selected bank array. Note that in functional mode 116 or mission mode of the multi-port memory (test mode not active), the address control logic is configured to ensure that when both read interfaces 110 are enabled (RE1 & RE2 == 1), the read interfaces 110 access different ones of bank arrays 306, 308 (AR1[n-1]! = AR2[n-1]), such as to prevent a conflict in data read from the memory array.

In aspects, the test circuitry 118 includes multiplexors 310 and 312 on the address bus of the read interfaces 110 to select which read address provided at the address inputs of the read interfaces is provided to the read logic of the bank arrays 306 and/or 308. As shown in Fig. 3, the outputs of the multiplexors 310 and 312 are clocked by flop logic 314 and 316 to provide address information to the bank 0 array 306 read logic and bank 1 array 308 read logic (e.g., based on read addresses at the address inputs). Generally, at least one of the multiple read interfaces 110 is assigned or designated a higher precedence or priority level (e.g., a primary read interface) over the other read interfaces such that when same bank access occurs, the address information of the designated read interface controls the read operation into the selected bank array 306, 308 or array of bit-cells.

In implementations with more than two read interfaces, a subset or all of the read interfaces may be assigned respective priority levels or precedence levels to ensure that, among various combinations of the read interfaces, a same bank access between the read interfaces has a single designated read interface with address information that controls access to the selected bank array. In this example, the control logic of the multiplexors 310 and 312 is configured such that read port 2 is designated as the primary test read interface. Thus, when a same bank access is attempted in the test mode, the address information of read port 2 controls the data read from and output by the bank array. In other words, when respective read addresses are received by the read logic of read port 1 (e.g., bank 0, address/row 9) and read port 2 (e.g., bank 0, address/row 11),

(AR1[n-1]==AR2[n-1]), then read address two (AR2), (e.g., bank 0, address/row 11), determines or controls what data will be provided on both read interface output ports. In aspects, output ports of the bank 0 array 306 and bank 1 array 308 are coupled to multiplexors 318 and 320, which are configured to selectively route the data read from the bank arrays based on flop logic 322 and 324 using the read enables to ensure that data read for a same bank access is provided to both output ports 326 and 328 of the read interfaces. Thus, the multiplexors 318 and 320 can route data read from the bank 0 array 306 and/or the bank 1 array 308 based on the read addresses and read enables (AR1[5] and RE1, AR2[5] and RE2) received at the flop logic 322 and 324. Note that in some cases, such as when the read interfaces 110 receive a same address (AR1==AR2), then both of the read interfaces would provide correct read data, which can be used during MBIST testing.

Generally, by enabling same bank reads during testing, the described aspects of multi-port memory testing address or remove the constraints typically imposed on ATPG testing tools with preceding testing techniques. This may in turn allow for improved pattern generation time (TAT), reduced test-time as a result of a reduction in pattern count to achieve same coverage, and with less rejection, the automated tools can generate more effective test patterns. Because ATPG typically works with a compression factor of 80x-150x, a simple constraint on 1 logic gate can influence hundreds of others and tool's ability to test them, without these same bank constraints, the tools are now able to generate multiple test vectors to improve overall test coverage and efficiency.

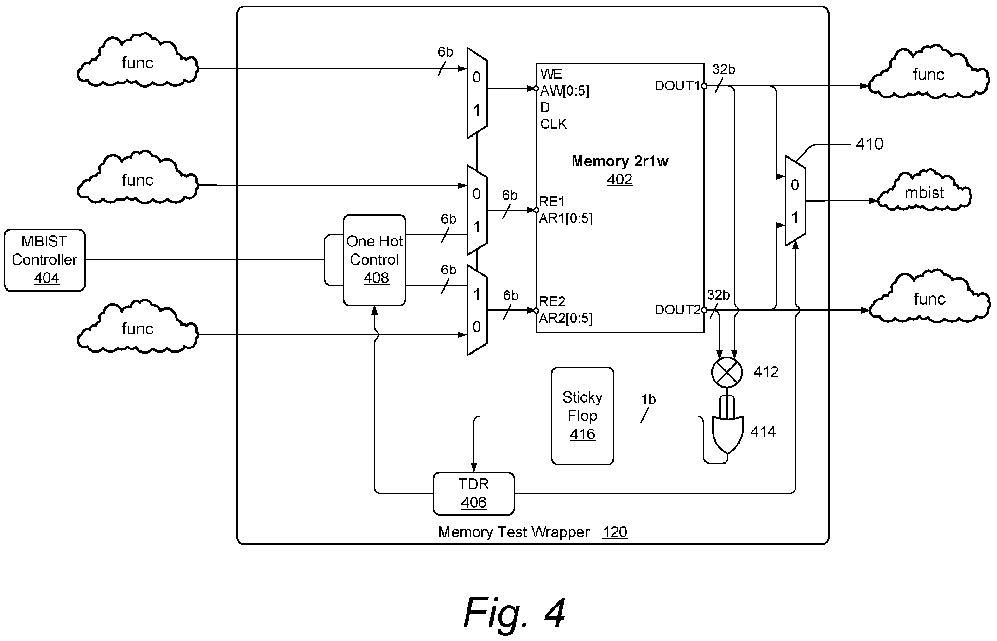

Fig. 4 illustrates at 400 an example test wrapper of a multi-port memory implemented in accordance with one or more aspects. Generally, the test wrapper 120 can be used to reduce test time for MBIST testing or other types of bit-read or bit-comparison types of testing. In aspects, the test wrapper 120 can selectively control address information provided to the read logic of the multi-port memory 402, which is illustrated as a 2 Read, 1 Write (2R1W) memory in this example. In the context of the two write ports, the test wrapper 120 is configured with the capability to indicate a correct data output at respective output ports of the read interfaces when AR1==AR2, which can reduce MBIST test time. Although shown in the context of MBIST testing, the test wrapper 120 can be enabled and/or applied during other types of memory bit-cell testing. As shown in Fig. 4, the test wrapper 120 is operably coupled with an MBIST controller 404, which can control a test data register 406 (TDR 406) and a one hot controller 408 of the memory test wrapper.

In aspects, the one hot controller 408 can broadcast address information to one address bus (e.g., a single "one hot" address), a subset of address busses, or all address busses for read interfaces 110 of a multi-port memory based on various control signals. In some cases, the MBIST controller 404 provides the address information to the one hot controller 408 and the TDR 406 may selectively route the address information to respective address logic or address busses of one or more of the read interfaces of the multi-port memory. Generally, by transmitting the same address information to address logic of multiple read interfaces, the respective outputs of those selected read interfaces should provide same read data as outputs of the read operations if the memory bit-cells of the addressed location are operating properly. The outputs of the read interfaces may also be coupled with a multiplexor 410, which the MBIST controller 404 may control to obtain data read out results for MBIST testing.

The test wrapper 120 also includes a comparator circuit with an exclusive OR (XOR) stage 412 that is coupled with multi-bit OR logic 414, which can provide an indicator of a bit mismatch to a sticky flop 416 circuit. In some cases, all data signals are gated by an MBIST mode to save power in functional mode. As shown in Fig. 4, the comparator circuit can implement a bit-wise compare the data outputs data 1 (DOUT1) and data 2 (DOUT2) with the XOR stage 412, aggregate the comparison results with the multi-bit OR logic 414, and sent the result or an indicator of the bit mismatch to the sticky flop 416. The TDR 406 can monitor an output of the sticky flop 416 to detect when a bit mismatch or error occurs during testing. In aspects, the TDR 406 can be accessed via an iJTAG port, which enables access and control of the TDR to implement one or more test modes. When unprogrammed for MBIST, the TDR may use the one hot controller 408 and/or the comparator circuit to implement the time-saving test scheme to compare the data provided at the output ports of the read interfaces. In a one hot mode, programming the TDR 406 with a pass_sel[n] value selects an n^{th} read interface for testing, which may also cause the one hot controller to block all other read interfaces. The TDR 406 can then observe pass or fail results for the selected read interface by reading the sticky flop 416 for an indication of failure.

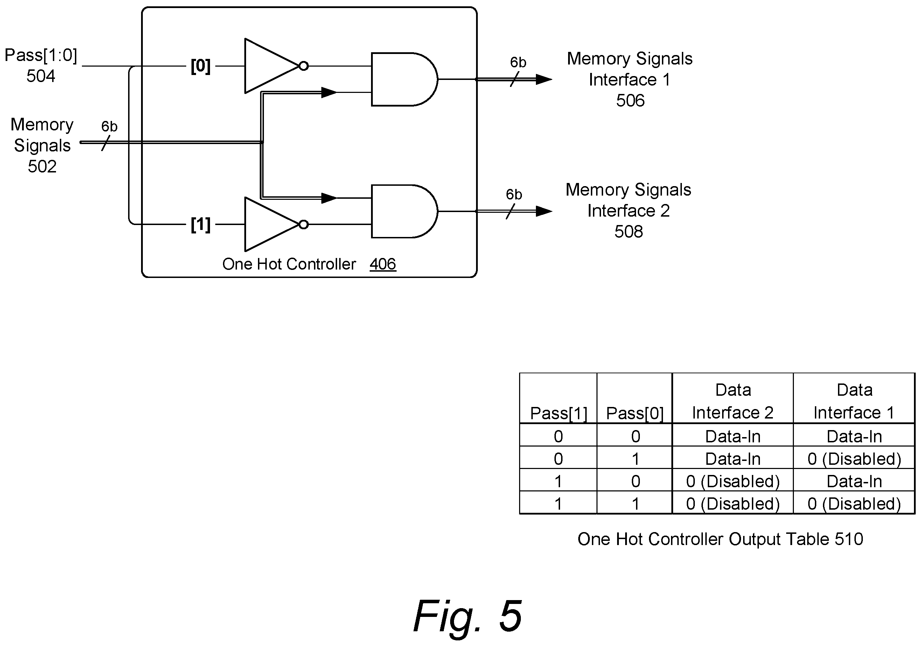

Fig. 5 illustrates at 500 an example one hot controller that can implement aspects of multi-port memory testing. Although described with reference to a multi-port memory with two read interfaces, circuitry of the one hot controller 408 may be expanded to any suitable number of read interface to selectively broadcast address information to one address bus, a subset of address busses, or all address busses of the multiple read interfaces. Generally, the one hot controller 408 can be configured to selectively broadcast, route, and/or block memory signals 502 (address information or an address) based on programming of the pass register 504 to route the address information to memory signal interface 1 506 and memory signal interface 2 508. Generally, the routing of memory signals or address information by the one hot controller 406 may follow the settings of the pass register 504 as indicated by the output table 510. For example, the pass register 504 may be configured to isolate a read interface to allow for debug modes in which only the selected interface is used as part of MBIST testing. In some cases, multiple instances of the one hot control circuit are added for each pair of optimized read/write interfaces.

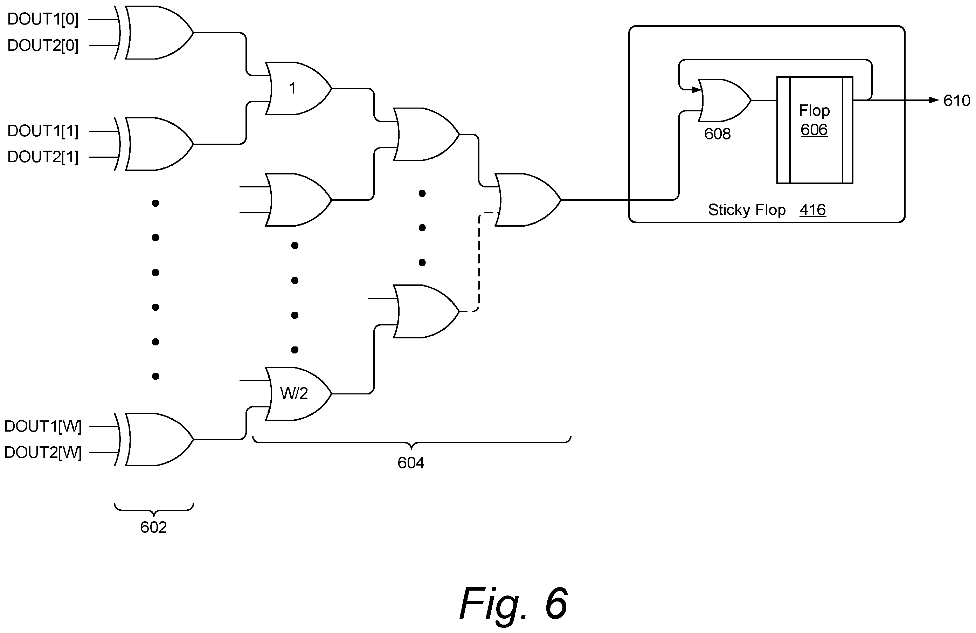

Fig. 6 illustrates an example comparison circuit that can implement aspects of multi-port memory testing. In some aspects, the comparison circuit includes an XOR stage 602, multi-bit OR logic 604, and an instance of a sticky flop 416. The sticky flop may be implemented with a flip-flop 606 and an OR gate 608 to receive a one-bit indicator from the multi-bit OR logic 604 and provide an indicator 610, which may be read by a TDR of a test wrapper or an MBIST controller. In aspects, the XOR stage 602 includes a quantity of W of the XOR gates that are configured to implement a bit-wise comparison between respective data read results provided at output ports of two read interfaces.

In this example, assume the output bus width of the read interfaces is 32 bits such that W is 32 and the XOR stage includes 32 XOR gates to implement the bit-wise comparison between the output data provided at the output ports of the read interfaces. To aggregate results of the bit-wise comparison, the multi-bit OR logic 604 may include a cascade circuit of OR gates disposed between the XOR gates and sticky flop or any other suitable arrangement of OR logic. As described herein, the multi-bit OR logic can be configured to provide, to the sticky flop 416, a single bit indication of the mismatch between the respective data read results of a first read interface and a second read interface. In aspects, the sticky flop 416 can be configured to receive the indication of a mismatch between the respective data read results, which can be latched or stored by the sticky flop 416 until read by the TDR 406 or MBIST controller 404. In some cases, the sticky flop 416 is configured to store the indication until cleared by the TDR 406 or a test control register.

### Example Methods

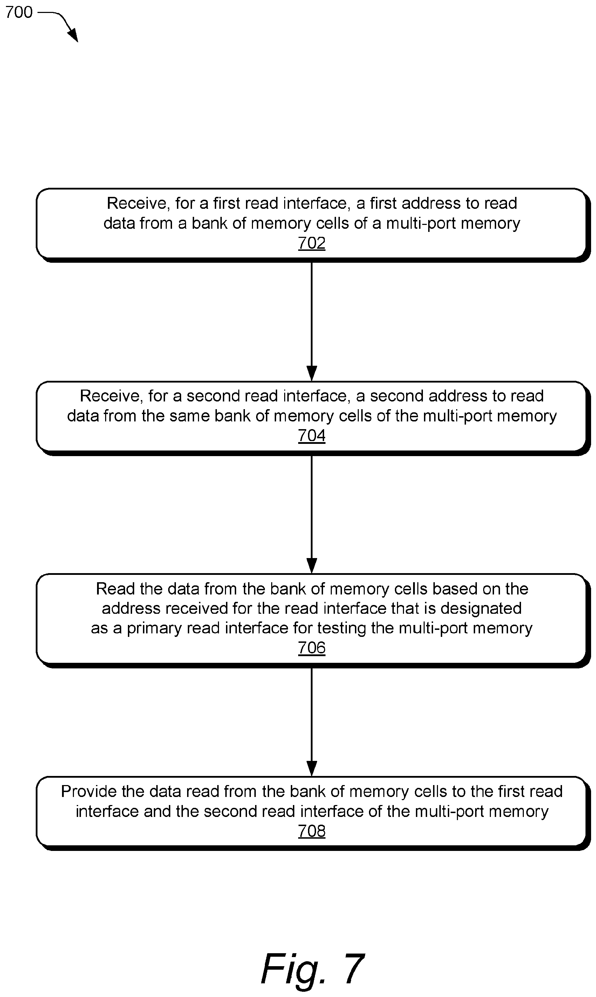

Example methods 700 through 900 are described with reference to Figs. 7-9 in accordance with one or more aspects of multi-port memory testing. Generally, the methods 700 through 900 illustrate sets of operations (or acts) performed in, but not necessarily limited to, the order or combinations in which the operations are shown herein. Further, any of one or more of the operations may be repeated, combined, reorganized, omitted, or linked to provide a variety of additional and/or alternate methods. In portions of the following discussion, reference may be made to example environments of Figs. 1 and 2, and/or entities described with reference to Figs. 3-6, reference to which is made for example only. The techniques and apparatuses described in this disclosure are not limited to embodiment or performance by one entity or multiple entities operating in relation to a multi-port memory device.

Fig. 7 illustrates an example method 700 for testing a multi-port memory in accordance with one or more aspects. In aspects, operations of the method 700 are implemented by or with interface logic 106, control logic 112, memory test circuitry 118, and/or memory test wrapper 120.

At 702, test circuitry of a multi-port memory receives, for a first read interface, a first address to read data from a bank of memory cells of the multi-port memory. For example, a test generator may provide the first address (e.g., row 11) to the first read interface to read from a second bank array (array 2) of the multi-port memory. At 704, the test circuitry receives, for a second read interface, a second address to read data from the same bank of memory cells of the multi-port memory. For example, the test generator may provide the second address (e.g., row 7) to the second read interface to read from the second bank array (array 2) of the multi-port memory.

At 706, the test circuitry directs the multi-port memory to read the data from the bank of memory cells based on the address received for the read interface that is designated as a primary read interface for testing the multi-port memory. In other words, the logic of the test circuitry may be configured to use address information of a designated read interface when bank selection bits of respective addresses for both read interfaces indicate an attempt at same bank access. In aspects, one or more of read interfaces of a multi-port memory may be assigned respective priority or precedence levels such that the response of the multi-port memory to same bank access is controlled or defined in a known manner to improve testability of the memory. In the context of the present example, the first read interface may be designated as the primary test read interface of the pair of read interfaces and the test circuitry may route the address information of the first read interface to addressing logic of the second bank array of the multi-port memory.

At 708, the multi-port memory provides the data read from the bank of memory cells to the first read interface and the second read interface of the multi-port memory. The test circuitry may use multiplexor circuits to route data read from the bank of memory cells to output ports of multiple read interfaces. The multiplexor circuit may be controlled based on a respective read enable status of the read interfaces and bank selection indicators within the address information received for each of the read interfaces. Concluding the present example, the test circuitry of the multi-port memory routes the data read from the second bank array at row 11 based on the address information for the first read interface.

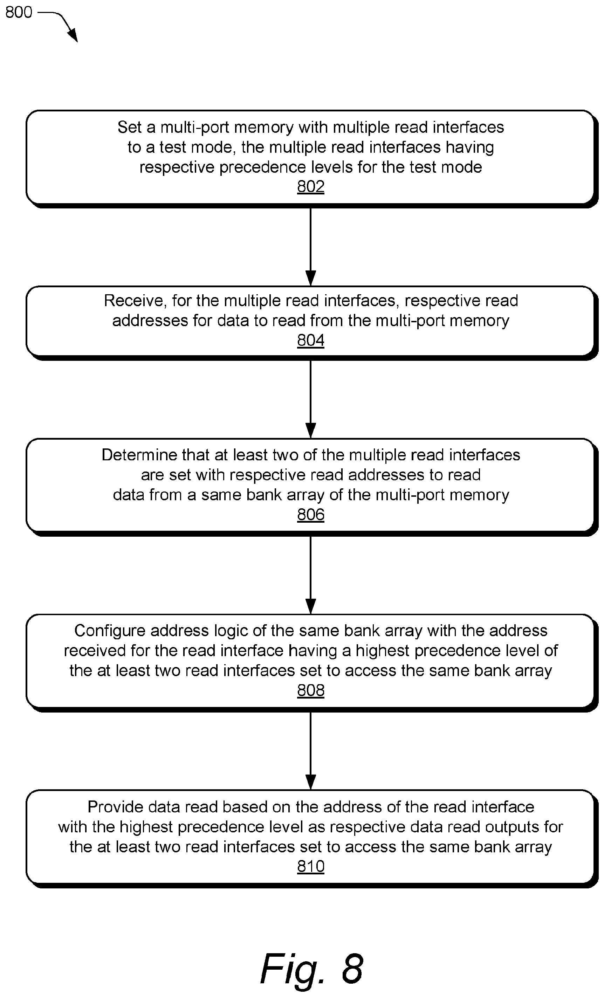

Fig. 8 illustrates an example method 800 for illustrates an example method for testing multiple read interfaces of a multi-port memory. In aspects, operations of the method 800 are implemented by or with interface logic 106, control logic 112, memory test circuitry 118, and/or memory test wrapper 120.

At 802, control logic of a multi-port memory with multiple read interfaces is set to a test mode. As described herein, the multiple read interfaces of the multi-port memory may be configured with respective precedence levels or priority levels for the test mode. In some cases, one read interface per pair of read interfaces may be designated with precedence or as a primary read interface for logic testing.

At 804, the multi-port memory receives, for the multiple read interfaces, respective read addresses for data to read from the multi-port memory. Each of the multiple read interfaces may receive a different respective read address or addressing information. At 806, a test circuitry determines that at least two of the multiple read interfaces are set with respective read addresses to read data from a same bank array (or array of bit-cells) of the multi-port memory.

At 808, the test circuitry configures address logic of the same bank array with the address received for the read interface having a highest precedence level of the at least two read interfaces set to access the same bank array. At 810, the multi-port memory provides data read from the bank array based on the address of the read interface with the highest precedence level as respective data read outputs for the at least two read interfaces set to access the same bank array.

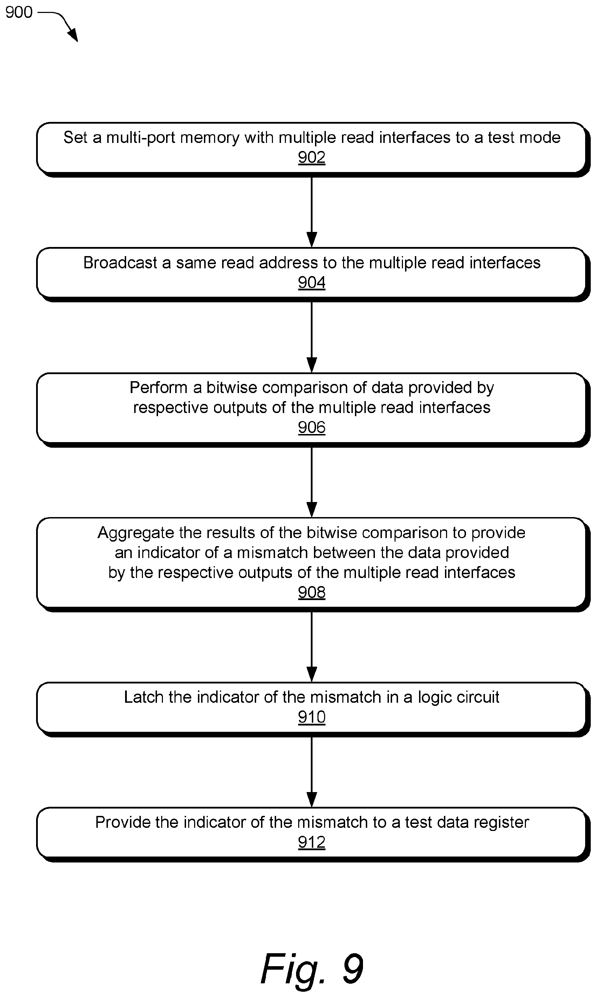

Fig. 9 illustrates an example method for detecting a mismatch between respective outputs of multiple read interfaces. In aspects, operations of the method 900 are implemented by or with interface logic 106, control logic 112, memory test circuitry 118, and/or memory test wrapper 120.

At 902, control logic of a multi-port memory with multiple read interfaces is set to a test mode. For example, an MBIST controller or a test data register of the multi-port memory may be set to or configured for a test mode via an iJTAG interface. In some cases, configuring the test mode includes configuring components of a test wrapper of the multi-port memory, which may include a one hot controller and output multiplexor.

At 904, the test wrapper of the multi-port memory broadcasts a same read address to the multiple read interfaces of the memory. As described herein, the test wrapper may use a one hot controller to broadcast the address or address information across multiple address busses or address logic of the multiple read interfaces. At 906, the test wrapper performs a bit-wise comparison of data provided by respective outputs of the multiple read interfaces. In some implementations, the test wrapper uses an XOR stage operably coupled to read output ports of the multiple read interfaces to implement the bit-wise comparison.

At 908, the test wrapper aggregates the results of the bit-wise comparison to provide an indicator of a mismatch between the data provided by the respective outputs of the multiple read interfaces. The test wrapper may use multi-bit OR logic or a cascade OR circuit to aggregate the outputs of the XOR stage to provide a one-bit or single signal that indicates a bit mismatch or error between the output ports of the read interfaces. At 910, the test wrapper captures the indicator of the mismatch in a logic gate. In aspects, a sticky flop or latch circuit of the test wrapper may capture or latch the indication provided by the OR logic circuit. At 912, the test wrapper provides the indicator of the mismatch to a test data register or an MBIST controller for further processing in relation to the testing of the multi-port memory.

### Example System-on-Chip

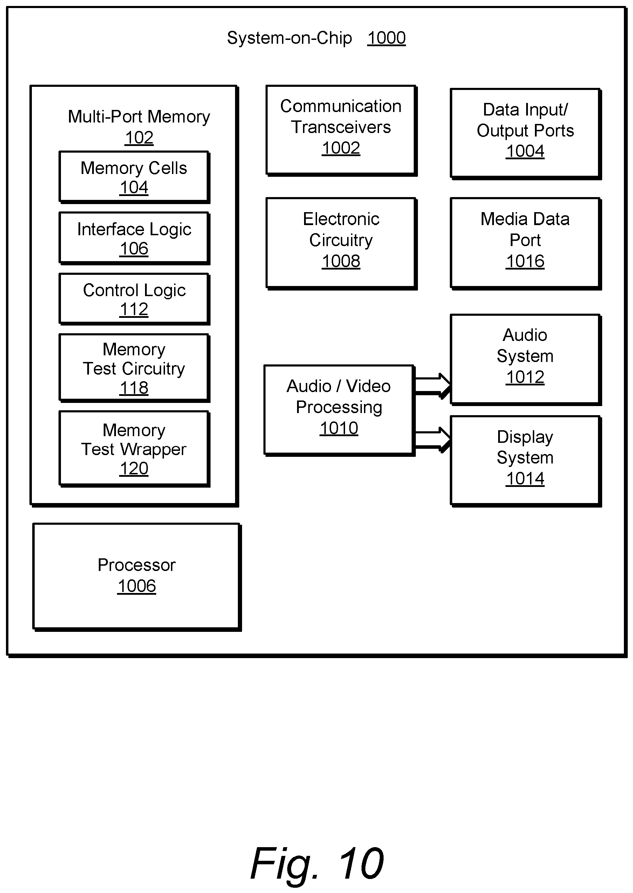

FIG. 10 illustrates various components of an example System-on-Chip 1000 (SoC 1000) that can implement multi-port memory testing in accordance with one or more aspects. The SoC 1000 may be implemented as any single or multiple of a fixed, mobile, stand-alone, or embedded device; in any form of a consumer, computer, portable, user, server, communication, phone, navigation, gaming, audio, camera, messaging, media playback, and/or other type of SoC 1000, which may include any suitable number of instances of a multi-port memory 102. One or more of the illustrated components may be realized as discrete components or as integrated components on at least one integrated circuit of the SoC 1000. Generally, the various components of the SoC 1000 are coupled via an interconnect and/or one or more fabrics that support communication between the components in accordance with one or more aspects of function call authorization.

The SoC 1000 can include one or more communication transceivers 1002 that enable wired and/or wireless communication of device data, such as received data, transmitted data, or other information identified above. Example communication transceivers 1002 include near-field communication (NFC) transceivers, wireless personal area network (PAN) (WPAN) radios compliant with various IEEE 802.15 (BluetoothTM) standards, wireless local area network (LAN) (WLAN) radios compliant with any of the various IEEE 802.11 (WiFiTM) standards, wireless wide area network (WAN) (WWAN) radios (e.g., those that are Third Generation Partnership Project compliant (3GPP-compliant)) for cellular telephony, wireless metropolitan area network (MAN) (WMAN) radios compliant with various IEEE 802.16 (WiMAXTM) standards, infrared (IR) transceivers compliant with an Infrared Data Association (IrDA) protocol, and wired local area network (LAN) (WLAN) Ethernet transceivers.

The SoC 1000 may also include one or more data input ports 1004 via which any type of data, media content, and/or other inputs can be received, such as user-selectable inputs, messages, applications, music, television content, recorded video content, and any other type of audio, video, and/or image data received from any content and/or data source, including a sensor like a microphone or a camera. The data input ports 1004 may include USB ports, coaxial cable ports, fiber optic ports for optical fiber interconnects or cabling, and other serial or parallel connectors (including internal connectors) for flash memory, DVDs, CDs, and the like. These data input ports 1004 may be used to couple the SoC to components, peripherals, or accessories such as keyboards, microphones, cameras, or other sensors.

The SoC 1000 of this example includes at least one processor 1006 (e.g., any one or more of application processors, microprocessors, digital signal processors (DSPs), controllers, and the like), which can include a combined processor and memory system (e.g., implemented as part of an SoC), that processes (e.g., executes) computer-executable instructions to control operation of the device. The processor 1006 may be implemented as an application processor, embedded controller, microcontroller, security processor, artificial intelligence (AI) accelerator, and the like. Generally, a processor or processing system may be implemented at least partially in hardware, which can include components of an integrated circuit or on chip system, a digital signal processor (DSP), an application-specific integrated circuit (ASIC), a field programmable gate array (FPGA), a complex programmable logic device (CPLD), and other implementations in silicon and/or other materials.

Alternatively or additionally, the SoC 1000 can be implemented with any one or combination of electronic circuitry, which may include software, hardware, firmware, or fixed logic circuitry that is implemented in connection with processing and control circuits, which are generally indicated at 1008 (as electronic circuitry 1008). This electronic circuitry 1008 can implement executable or hardware-based modules (not shown in FIG. 10), such as through processing/computer-executable instructions stored on computer-readable media, through logic circuitry and/or hardware (e.g., such as an FPGA), and so forth.

The SoC 1000 also includes one or more instances of the multi-port memory 102 and/or other memory devices that enable data storage, examples of which include random access memory (RAM), non-volatile memory (e.g., read-only memory (ROM), flash memory, erasable programable read-only memory (EPROM), and electrically-erasable programable read-only memory (EEPROM)), and a disk storage device. Thus, the memory devices of the SoC 1000 can be distributed across different logical storage levels of a system as well as at different physical components. The memory devices provide data storage mechanisms to store the device data, other types of code and/or data, and various device applications (e.g., software applications or programs). For example, an operating system can be maintained as software instructions within the memory device, such as multi-port memory 102, and executed by the processor 1006.

As shown in Fig. 10, the multi-port memory 102 can include memory cells 104, interface logic 106, control logic 112, test circuitry 118, and a memory test wrapper 120, which may be implemented as described with reference to Figs. 1-9. In aspects, the test circuitry 118 may enable same bank access by controlling a response provided at the outputs of the multiple read interfaces. For example, the test circuitry 118 may be configured such that the multiple read interfaces are assigned respective precedence levels or priority levels to determine a response of the memory when same bank access occurs during testing. Thus, when same bank access is attempted by the test algorithm, the data read results provided at the output logic of the bank array may follow the read interface with the highest precedence or priority level (and disregard other interfaces with lower precedence). This may enable the test algorithm to implement test patterns or test configurations that were previously constrained with preceding testing techniques.

Alternatively or additionally, the test wrapper 120 can selectively broadcast address information to all or a subset of the multiple read interfaces or a single read interface during testing. The test wrapper 120 may also implement fault detection across the outputs of the multiple read interfaces to flag a data mismatch between the read interfaces. For example, when implementing an MBIST test, the test wrapper 120 can broadcast address information to the multiple read interfaces to read from a same memory location with a bit-cell array or bank array. The test wrapper 120 can then implement a bit-wise comparison across the respective outputs of the read interfaces and detect any bit mismatches between the respective outputs that should have a same bit pattern due to the broadcasting of the address information across the read interfaces. By so doing, the test circuitry 118 and/or the test wrapper 120 as described herein can reduce testing constraints and reduce test time for multi-port memories.

In some implementations, the SoC 1000 also includes an audio and/or video processing system 1010 that processes audio data and/or passes through the audio and video data to an audio system 1012 and/or to a display system 1014 (e.g., a video buffer or a screen of a smartphone or camera). The audio system 1012 and/or the display system 1014 may include any devices that process, display, and/or otherwise render audio, video, display, and/or image data. Display data and audio signals can be communicated to an audio component and/or to a display component via an RF (radio frequency) link, S video link, HDMI (high-definition multimedia interface), composite video link, component video link, DVI (digital video interface), analog audio connection, video bus, or other similar communication link, such as a media data port 1016. In some implementations, the audio system 1012 and/or the display system 1014 are external or separate components of the SoC 1000. Alternatively, the display system 1014, for example, can be an integrated component of the example SoC 1000, such as part of an integrated touch interface.

### Conclusion

Although aspects of the described apparatuses and techniques for multi-port memory testing have been described in language specific to features and/or methods, the subject of the appended claims is, as recited by any of the previous examples, not necessarily limited to the specific features or methods described. Rather, the specific features and methods are disclosed as example implementations of multi-port memory testing, and other equivalent features and methods are intended to be within the scope of the appended claims. Further, various aspects of multi-port memory testing are described, and it is to be appreciated that each described aspect can be implemented independently or in connection with one or more other described aspects.

## Claims

1. A multi-port memory (102) comprising:
an array of memory cells (104) organized into multiple banks of memory cells (306, 308);
interface logic (106) comprising multiple read interfaces (110), the multiple read interfaces including a first read interface and a second read interface for the multiple banks of memory cells;
test circuitry (118) configured to:
receive, for the first read interface, a first address to read data from one bank of memory cells;
receive, for the second read interface, a second address to read data from a same bank of memory cells, the first address being different from the second address;
cause the interface logic (106) to read the data from the bank of memory cells based on the address received for the read interface that is designated as a primary read interface for testing the multi-port memory; and
provide the data read from the bank of memory cells to both of the first read interface and the second read interface of the multi-port memory.

2. The multi-port memory (102) as recited in claim 1, wherein to cause the interface logic (106) to read the data from the memory cells (104), the test circuitry (118) is configured to disregard the address received for the read interface that is not designated as the primary read interface when the first address and the second address indicate the same bank of memory cells (306, 308).

3. The multi-port memory (102) as recited in claim 1 or 2, wherein the test circuitry (118) enables concurrent read operations by the first read interface and the second read interface on the same bank of memory cells (306, 308).

4. The multi-port memory (102) as recited in claim 1, 2 or 3, further comprising address logic configured to prevent, for the multiple read interfaces (110), concurrent read access to the same bank of the memory cells (306, 308) when the test circuitry (118) is not active.

5. The multi-port memory (102) as recited in any preceding claim, further comprising, for each of the multiple banks of memory cells (306, 308):
address logic for the bank of memory cells, and wherein the test circuitry (118) further comprises:
a multiplexor (310, 312) having inputs configured to receive addresses for the multiple read interfaces (110) and an output coupled with an input of the address logic for the bank of memory cells (306, 308); and
control logic operably coupled to the multiplexor and configured to select, for routing to the address logic of the bank of memory cells, the address received for the primary read interface.

6. The multi-port memory (102) as recited in claim 5, wherein the control logic is configured to operate based on the address received for the primary read interface for testing the multi-port memory.

7. The multi-port memory (102) as recited in any preceding claim, further comprising, for each of the multiple read interfaces (110):
a multiplexor (318, 320) having inputs coupled with respective outputs of the multiple banks of memory cells (306, 308) and an output configured to provide, as an output of the read interface, data read from one of the respective outputs of the multiple banks of memory cells, and wherein the test circuitry (118) further comprises:
output logic (322, 324) configured to select, from the respective outputs of the multiple banks of memory cells, the respective output of the same bank of memory cells that is selected by the address received for the primary read interface.

8. The multi-port memory (102) as recited in any preceding claim, wherein:
a bit of the first address selects the bank of the memory cells (306, 308); and
a bit of the second address selects the same bank of the memory cells.

9. The multi-port memory (102) as recited in any preceding claim, wherein:
the first address received for the first read interface indicates a first row of the bank of memory cells (306, 308); and
the second address received for the second read interface indicates a second row of the bank of memory cells that is different from the first row.

10. The multi-port memory (102) as recited in any preceding claim, wherein testing the multi-port memory comprises automatic test pattern generation testing.

## Patentansprüche

1. Multiportspeicher (102), umfassend:
ein Array von Speicherzellen (104), die in mehrere Bänke von Speicherzellen (306, 308) organisiert sind;
eine Schnittstellenlogik (106), umfassend mehrere Leseschnittstellen (110), wobei die mehreren Leseschnittstellen eine erste Leseschnittstelle und eine zweite Leseschnittstelle für die mehreren Banken von Speicherzellen beinhalten;
eine Testschaltung (118), die dazu konfiguriert ist:
für die erste Leseschnittstelle eine erste Adresse zu empfangen, um Daten aus einer Bank von Speicherzellen zu lesen;
für die zweite Leseschnittstelle eine zweite Adresse zu empfangen, um Daten aus derselben Bank von Speicherzellen zu lesen, wobei sich die erste Adresse von der zweiten Adresse unterscheidet;
zu bewirken, dass die Schnittstellenlogik (106) die Daten aus der Bank von Speicherzellen basierend auf der für die Leseschnittstelle empfangenen Adresse, die als primäre Leseschnittstelle zum Testen des Multiportspeichers bezeichnet ist, liest; und
die aus der Bank von Speicherzellen gelesenen Daten sowohl der ersten Leseschnittstelle als auch der zweiten Leseschnittstelle des Multiportspeichers bereitzustellen.

2. Multiportspeicher (102) nach Anspruch 1, wobei die Testschaltung (118) zum Bewirken, dass die Schnittstellenlogik (106) die Daten aus den Speicherzellen (104) liest, dazu konfiguriert ist, die für die Leseschnittstelle empfangene Adresse zu ignorieren, die nicht als primäre Leseschnittstelle bezeichnet ist, wenn die erste Adresse und die zweite Adresse auf dieselbe Bank von Speicherzellen (306, 308) hinweisen.

3. Multiportspeicher (102) nach Anspruch 1 oder 2, wobei die Testschaltung (118) gleichzeitige Lesevorgänge durch die erste Leseschnittstelle und die zweite Leseschnittstelle auf derselben Bank von Speicherzellen (306, 308) ermöglicht.

4. Multiportspeicher (102) nach Anspruch 1, 2 oder 3, ferner umfassend eine Adresslogik, die dazu konfiguriert ist, für die mehreren Leseschnittstellen (110) einen gleichzeitigen Lesezugriff auf dieselbe Bank der Speicherzellen (306, 308) zu verhindern, wenn die Testschaltung (118) nicht aktiv ist.

5. Multiportspeicher (102) nach einem der vorhergehenden Ansprüche, ferner umfassend für jede der mehreren Banken von Speicherzellen (306, 308):
eine Adresslogik für die Bank von Speicherzellen, und wobei die Testschaltung (118) ferner Folgendes umfasst:
ein Multiplexer (310, 312), der Eingänge, die dazu konfiguriert sind, Adressen für die mehreren Leseschnittstellen (110) zu empfangen, und einem Ausgang aufweist, der mit einem Eingang der Adresslogik für die Bank von Speicherzellen (306, 308) gekoppelt ist; und
eine Steuerlogik, die mit dem Multiplexer wirkverbunden und dazu konfiguriert ist, zum Routing zu der Adresslogik der Bank von Speicherzellen die Adresse auszuwählen, die für die primäre Leseschnittstelle empfangen wird.

6. Multiportspeicher (102) nach Anspruch 5, wobei die Steuerlogik dazu konfiguriert ist, basierend auf der Adresse zu arbeiten, die für die primäre Leseschnittstelle zum Testen des Multiportspeichers empfangen wird.

7. Multiportspeicher (102) nach einem der vorhergehenden Ansprüche, ferner umfassend für jede der mehreren Leseschnittstellen (110):
einen Multiplexer (318, 320), der Eingänge, die mit jeweiligen Ausgängen der mehreren Banken von Speicherzellen (306, 308) gekoppelt sind, und einen Ausgang aufweist, der dazu konfiguriert ist, als Ausgang der Leseschnittstelle Daten bereitzustellen, die aus einem der jeweiligen Ausgänge der mehreren Banken von Speicherzellen gelesen werden, wobei die Testschaltung (118) ferner Folgendes umfasst:
eine Ausgangslogik (322, 324), die dazu konfiguriert ist, aus den jeweiligen Ausgängen der mehreren Bänke von Speicherzellen den jeweiligen Ausgang derselben Bank von Speicherzellen auszuwählen, die durch die für die primäre Leseschnittstelle empfangene Adresse ausgewählt wird.

8. Multiportspeicher (102) nach einem der vorhergehenden Ansprüche, wobei:
ein Bit der ersten Adresse die Bank der Speicherzellen (306, 308) auswählt; und
ein Bit der zweiten Adresse dieselbe Bank der Speicherzellen auswählt.

9. Multiportspeicher (102) nach einem der vorhergehenden Ansprüche, wobei:
die erste Adresse, die für die erste Leseschnittstelle empfangen wird, auf eine erste Reihe der Bank von Speicherzellen (306, 308) hinweist; und
die zweite Adresse, die für die zweite Leseschnittstelle empfangen wird, auf eine zweite Reihe der Bank von Speicherzellen hinweist, die sich von der ersten Reihe unterscheidet.

10. Multiportspeicher (102) nach einem der vorhergehenden Ansprüche, wobei das Testen des Multiportspeichers ein automatisches Testmustererzeugungstesten umfasst.

## Revendications

1. Mémoire multiport (102) comprenant :
un réseau de cellules de mémoire (104) organisé en de multiples banques de cellules de mémoire (306, 308) ;
une logique d'interface (106) comprenant de multiples interfaces de lecture (110), les multiples interfaces de lecture comportant une première interface de lecture et une seconde interface de lecture pour les multiples banques de cellules de mémoire ;
un ensemble de circuits de test (118) configuré pour :
recevoir, pour la première interface de lecture, une première adresse pour lire des données à partir d'une banque de cellules de mémoire ;
recevoir, pour la seconde interface de lecture, une seconde adresse pour lire des données à partir d'une même banque de cellules de mémoire, la première adresse étant différente de la seconde adresse ;
amener la logique d'interface (106) à lire les données à partir de la banque de cellules de mémoire sur la base de l'adresse reçue pour l'interface de lecture qui est désignée comme interface de lecture principale pour tester la mémoire multiport ; et
fournir les données lues à partir de la banque de cellules de mémoire tant à la première interface de lecture qu'à la seconde interface de lecture de la mémoire multiport.

2. Mémoire multiport (102) selon la revendication 1, dans laquelle, pour amener la logique d'interface (106) à lire les données à partir des cellules de mémoire (104), l'ensemble de circuits de test (118) est configuré pour ignorer l'adresse reçue pour l'interface de lecture qui n'est pas désignée comme interface de lecture principale lorsque la première adresse et la seconde adresse indiquent la même banque de cellules de mémoire (306, 308).

3. Mémoire multiport (102) selon la revendication 1 ou 2, dans laquelle l'ensemble de circuits de test (118) permet des opérations de lecture simultanées par la première interface de lecture et la seconde interface de lecture sur la même banque de cellules de mémoire (306, 308).

4. Mémoire multiport (102) selon la revendication 1, 2 ou 3, comprenant en outre une logique d'adresse configurée pour empêcher, pour les multiples interfaces de lecture (110), un accès en lecture simultané à la même banque de cellules de mémoire (306, 308) lorsque l'ensemble de circuits de test (118) n'est pas actif.

5. Mémoire multiport (102) selon une quelconque revendication précédente, comprenant en outre, pour chacune des multiples banques de cellules de mémoire (306, 308) :
une logique d'adresse pour la banque de cellules de mémoire, et dans laquelle l'ensemble de circuits de test (118) comprend en outre :
un multiplexeur (310, 312) ayant des entrées configurées pour recevoir des adresses pour les multiples interfaces de lecture (110) et une sortie couplée à une entrée de la logique d'adresse pour la banque de cellules de mémoire (306, 308) ; et
une logique de commande couplée fonctionnellement au multiplexeur et configurée pour sélectionner, en vue de l'acheminement vers la logique d'adresse de la banque de cellules de mémoire, l'adresse reçue pour l'interface de lecture principale.

6. Mémoire multiport (102) selon la revendication 5, dans laquelle la logique de commande est configurée pour fonctionner sur la base de l'adresse reçue pour l'interface de lecture principale pour tester la mémoire multiport.

7. Mémoire multiport (102) selon une quelconque revendication précédente, comprenant en outre, pour chacune des multiples interfaces de lecture (110) :
un multiplexeur (318, 320) ayant des entrées couplées aux sorties respectives des multiples banques de cellules de mémoire (306, 308) et une sortie configurée pour fournir, en tant que sortie de l'interface de lecture, des données lues à partir de l'une des sorties respectives des multiples banques de cellules de mémoire, et dans laquelle l'ensemble de circuits de test (118) comprend en outre :
une logique de sortie (322, 324) configurée pour sélectionner, parmi les sorties respectives des multiples banques de cellules de mémoire, la sortie respective de la même banque de cellules de mémoire qui est sélectionnée par l'adresse reçue pour l'interface de lecture principale.

8. Mémoire multiport (102) selon une quelconque revendication précédente, dans laquelle :
un bit de la première adresse sélectionne la banque de cellules de mémoire (306, 308) ; et
un bit de la seconde adresse sélectionne la même banque de cellules de mémoire.

9. Mémoire multiport (102) selon une quelconque revendication précédente, dans laquelle :
la première adresse reçue pour la première interface de lecture indique une première rangée de la banque de cellules de mémoire (306, 308) ; et
la seconde adresse reçue pour la seconde interface de lecture indique une seconde rangée de la banque de cellules de mémoire qui est différente de la première rangée.

10. Mémoire multiport (102) selon une quelconque revendication précédente, dans laquelle le test de la mémoire multiport comprend un test par génération automatique de motifs de test.
